Europäisches Patentamt

European Patent Office

Office européen des brevets

(11) Publication number: **0 099 931**
**B1**

# EUROPEAN PATENT SPECIFICATION

(45) Date of publication of patent specification: **13.06.90**

(21) Application number: **83900360.5**

(22) Date of filing: **24.01.83**

(86) International application number:
**PCT/JP83/00020**

(87) International publication number:
**WO 83/02678 04.08.83 Gazette 83/18**

(51) Int. Cl.⁵: **G 11 C 19/28,** G 11 C 27/00 //
H01L29/76

(54) **SHIFT REGISTER.**

(30) Priority: **29.01.82 JP 14181/82**

(43) Date of publication of application:
**08.02.84 Bulletin 84/06**

(45) Publication of the grant of the patent:
**13.06.90 Bulletin 90/24**

(84) Designated Contracting States:
**DE FR GB NL**

(56) References cited:
**DE-A-1 541 923
JP-A-4 957 739
JP-A-5 004 950**

**PROCEEDINGS OF THE FALL JOINT COMPUTER CONFERENCE, 16th-18th November 1971, AFIPS Press, 1971, pages 171-176, Montvale, New Jersey, US; TEH-SEN JEN: "A new approach to implementing high-density shift registers"**

**Takeishi Yoshiyuki, Kayama Susumu Kanyaku "Denka Tenso Device CCD, BBD no kiso to Oyo" 20. February 1978 (200278), Kindai Kagakusha, pages 17-37, 224-240**

(73) Proprietor: **SONY CORPORATION**
7-35 Kitashinagawa 6-Chome Shinagawa-ku
Tokyo 141 (JP)

(72) Inventor: **SATO, Maki**
Sony Corporation 7-35, Kitashinagawa 6-chome
Shinagawa-ku Tokyo 141 (JP)
Inventor: **NARABU, Tadakuni**
Sony Corporation 7-35, Kitashinagawa 6-chome
Shinagawa-ku Tokyo 141 (JP)
Inventor: **HASHIMOTO, Takeo**
Sony Corporation 7-35, Kitashinagawa 6-chome
Shinagawa-ku Tokyo 141 (JP)

(74) Representative: **Thomas, Christopher Hugo et al**
D Young & Co 10 Staple Inn
London WC1V 7RD (GB)

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

This invention relates to shift registers.

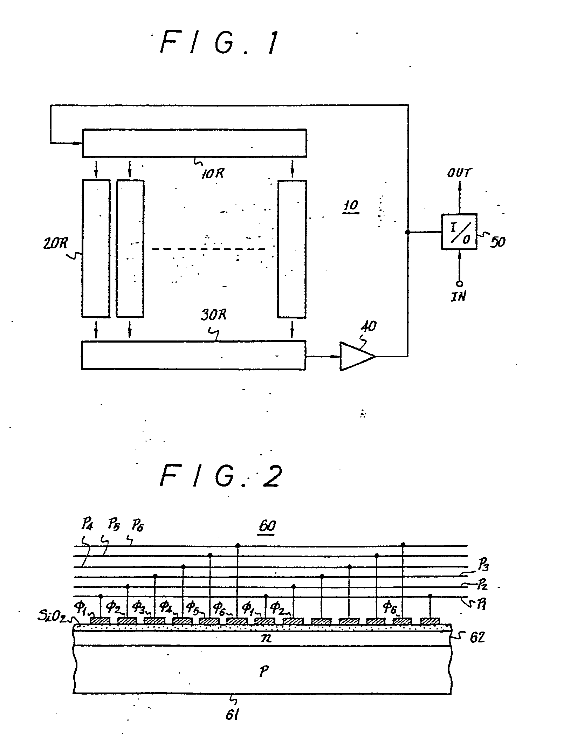

Figure 1 shows an example of a memory 10 having a serial-parallel-serial (SPS) configuration formed by a charge coupled device (CCD). This memory comprises a serial shift register (input shift register) 10R, parallel shift registers (parallel transfer shift registers) 20R, the number of which corresponds to the effective bit length of the serial shift register 10R, and a serial shift register (output shift register) 30R. The output from the output shift register 30R is reproduced by a reproducing circuit 40 and then fed to an input/output circuit 50. A part of such output is fed back to the input shift register 10R and rewritten therein.

The bit length of the memory 10 is predetermined when the shift registers 10R to 30R and the peripheral circuits (such as drive circuits) are constructed, so there is no freedom for selecting the use and bit length of the memory 10.

The Proceedings of the Fall Joint Computer Conference, 16 to 18 November 1971, AFIPS Press 1971, pages 171 to 176, disclose a shift register which in principle is in accordance with the precharacterising part of the claim.

According to the present invention there is provided a shift register comprising an n-phase and m-bit charge transfer type shift register and a drive circuit for said shift register, wherein the bit capacity of said shift register can be varied to (n-1)m/n bits at maximum by driving said shift register on the basis of a predetermined transfer clock which is generated from said drive circuit; characterized in that:

said drive circuit comprises a transfer clock generator producing clock data, and a bi-directional m-bit shift register receiving said clock data via selection means either on a first input for selection of a first transfer (electrode/bit transfer), whereby the clock data is shifted in turn in said shift register in a first direction, or on a second input for selection of a second transfer (ordinary transfer), whereby the clock data is shifted in turn in said shift register in the other direction, and a respective clock driver connected to each of the bits of said bi-directional shift register, the effective bit length of the shift register being determined by the bits of the clock data and by selecting the transfer direction.

The invention will now be described by way of example with reference to the accompanying drawings, throughout which like parts are referred to by like references, and in which:

Figure 1 is a block diagram of a memory having an SPS configuration;

Figure 2 is a cross-sectional diagram for explaining a shift register formed of a CCD;

Figure 3 is a block diagram showing an example of a circuit which drives a shift register;

Figures 4 to 8 are diagrams for explaining the operation of an embodiment of the invention;

Figure 9 is a construction diagram showing an example of a shift register; and

Figures 10 to 15 are further diagrams for explaining the operation of an embodiment of the invention.

Figure 2 and the succeeding drawings relate to an embodiment of shift register according to the present invention, the shift register 60 comprising a buried channel type CCD having a 6-phase transfer clock shift, by way of example.

The shift register 60 comprises a P type substrate, a buried N type diffusion layer 62 and transfer electrodes φ1 to φ6. When predetermined transfer clocks (determined by clock data which will be described later) P1 to P6 are supplied to a plurality of the transfer electrodes φ1 to φ6, the transfer of data is carried out.

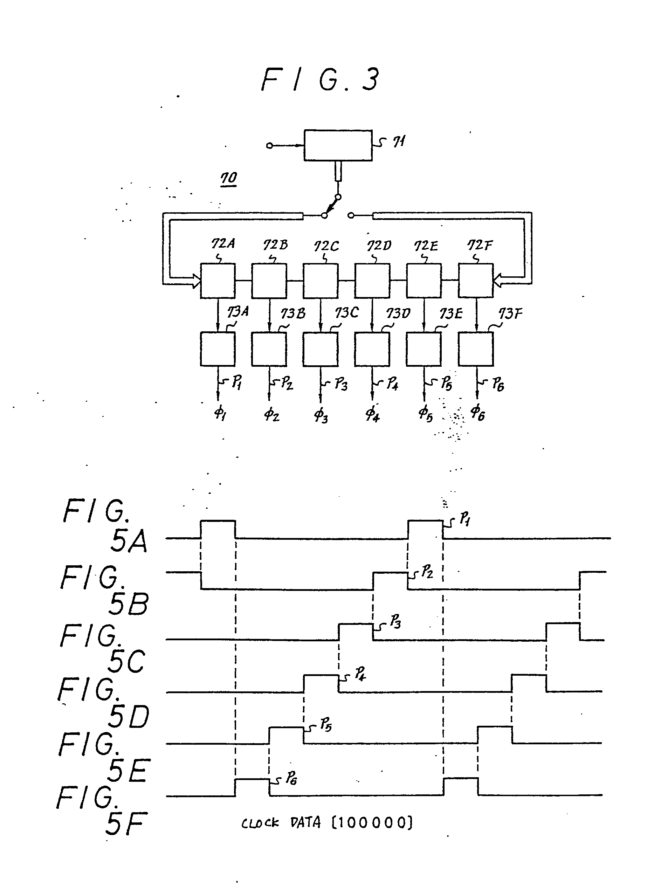

Figure 3 is an example of a drive circuit for the shift register 60, and comprises a transfer clock generator 71 which can be externally controlled, and which produces data of a clock for use with electrode/bit (E/B) transfer, and data of a clock for use with ordinary transfer, and bi-directional shift registers 72A to 72F. When the clock data are supplied to the shift register 72A, the clock data are shifted in turn by one bit each from the left-hand shift register 72A to the right-hand shift register 72F. On the other hand, when the clock data are supplied to the right-hand shift register 72F, the clock data are shifted in turn by one bit each from the right-hand shift register 72F to the left-hand shift register 72A. The outputs from the shift registers 72A to 72F are respectively supplied through clock drivers 73A to 73F to the transfer electrodes φ1 to φ6 shown in Figure 2 as their transfer clocks.

The effective bit length of the shift register 60 is determined by the kinds of clock data produced from the transfer clock generator 71, and by selecting the transfer system as either the E/B transfer or the ordinary transfer. In the case of the n-phase and m-bit (m represents the total number of the transfer electrodes φ1 to φ6) shift register 60, the effective bit length can be extended from m/n bits to (n-1)m/n bits at maximum. In the case of a 6-phase and m-bit shift register 60, if the kinds of transfer clock and the transfer mode are selected properly, the effective bit length can be varied from m/6 bits to 5m/6 bits.

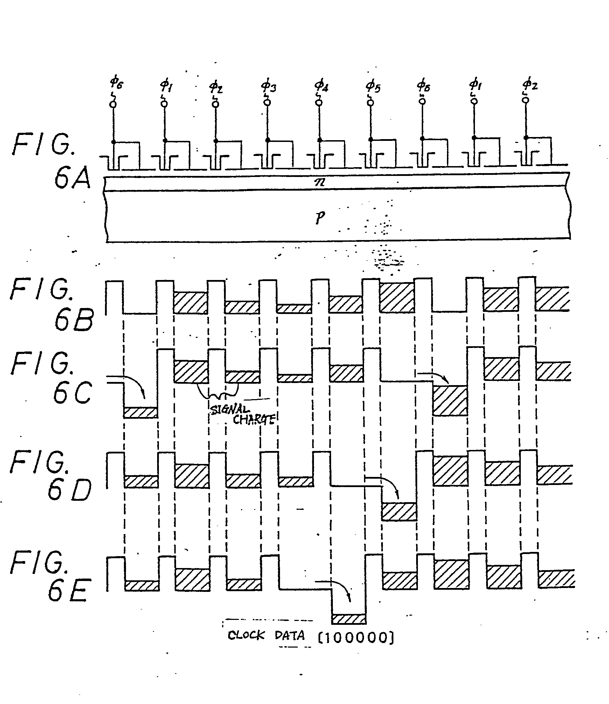

Firstly, an example in which the effective bit length of 5m/6 bits is obtained will be described. In this case, data 100000 are used as the clock data and the E/B transfer is selected as the transfer system. Accordingly, the clock data are supplied to the right-hand shift register 72F, so that time sequential transfer clocks as shown in Figure 5 are supplied to the transfer electrodes φ1 to φ6.

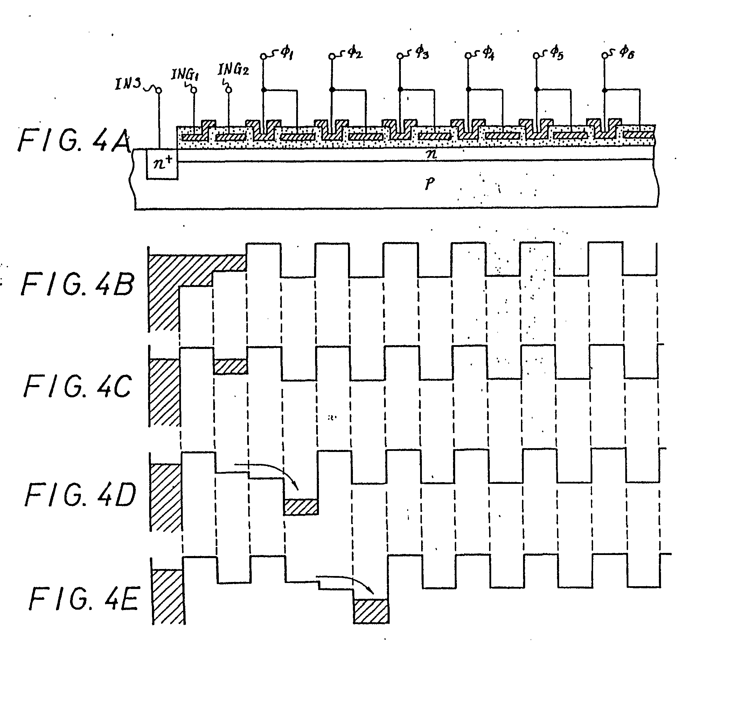

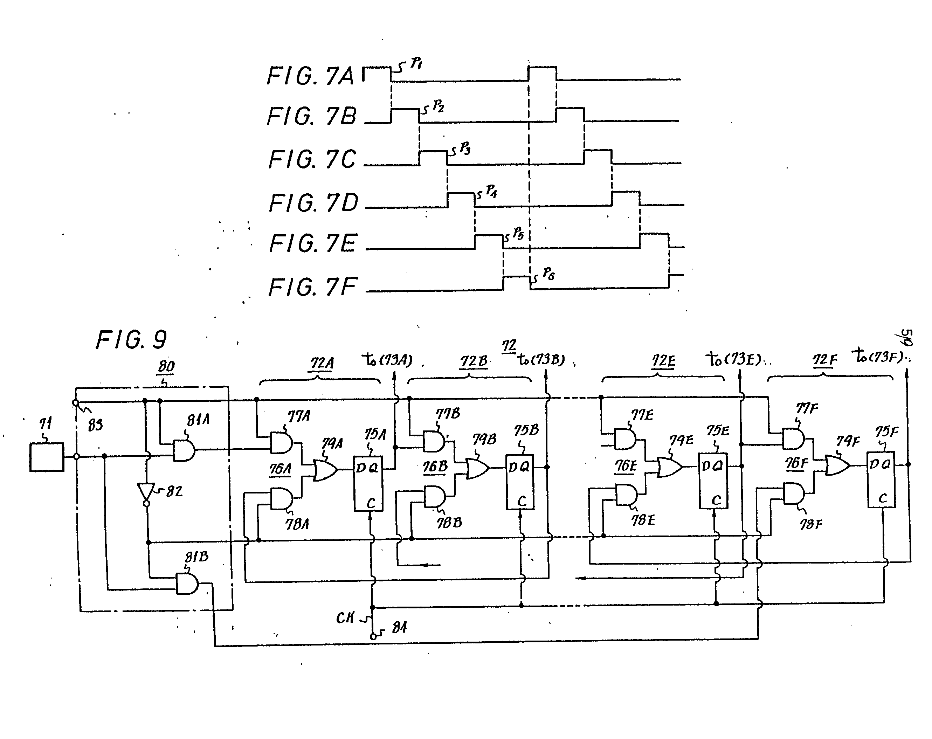

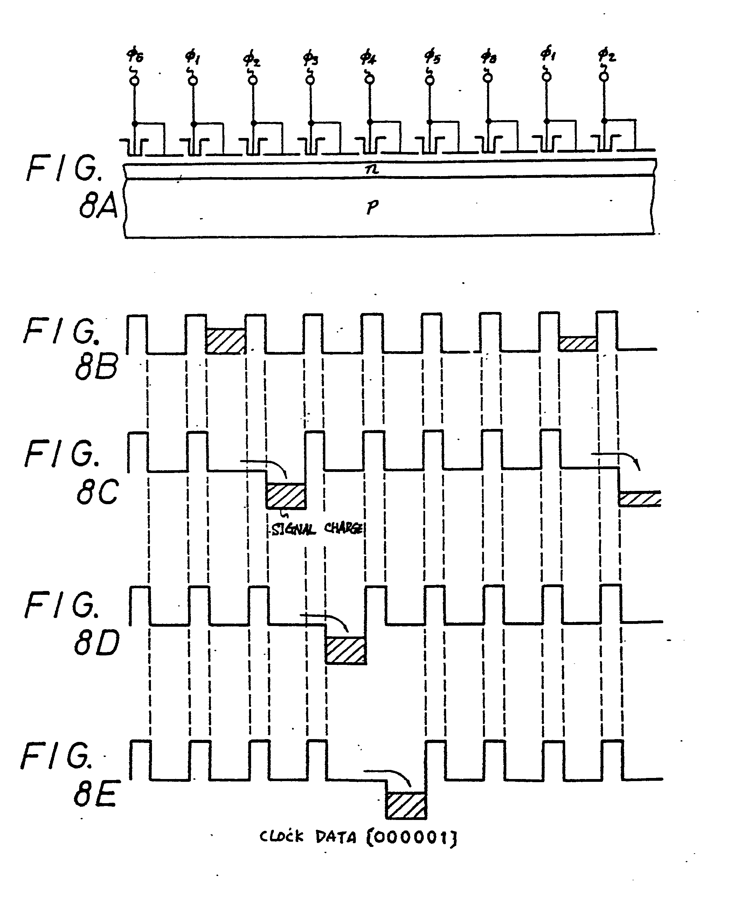

When a single signal charge is taken in and then transferred, the shift register 60 is set to a mode shown in Figure 4. A predetermined DC bias is applied to a second input gate ING2 and a lock clock which changes at each predetermined period is applied to a first input gate ING1 with the result that as shown in Figure 4B, after the predetermined signal charge has been applied from an input source INS to the input gates, the signal charge is transferred such that it is shifted in turn by one bit each as shown in Figures 4C to 4E by the transfer clocks (an example of such clock data is shown in Figure 7) supplied to the transfer electrodes φ1 to φ6.

Figure 6 shows such a transfer mode in which signal charges are accumulated in the wells beneath all the transfer electrodes φ1 to φ6. Since the clock data are in the E/B transfer mode and shifted in turn from the right-hand side to the left-hand side of the shift register 60, the change of the well for the signal charge is moved from the right-hand side to the lefthand side as shown in the figure. When the signal charges are accumulated in the wells beneath a plurality of transfer electrodes as described above, the data must be shifted by one bit each by the transfer clock. Therefore, in the case of a 6-phase clock, the input data are so controlled that an empty charge is presented in the well having the quantity of one bit at minimum. Accordingly, in the case of a 6-phase clock, the shift register 60 has the capacity of 6 - 1 = 5 bits at maximum.

In consequence, when the number of transfer clock electrodes φ1 to φ6 in the whole of the shift register 60 is m, the whole effective bit length becomes 5m/6 bits.

When the transfer system is changed from the E/B transfer to the ordinary transfer with the same transfer clock data, the clock data are supplied to the left-hand side shift register 72A so that the transfer clocks P1 to P6 as shown in Figure 5 are sequentially supplied to the respective transfer electrodes φ1 to φ6. As a result, the well is sequentially moved left to right by the clock data (see Figure 8). Also, since the data are allowed to be supplied to the transfer electrode φ1 after 6 bits have been shifted, even under 6-phase driving, the data is supplied to only one phase thereof. Thus, even with the 6-phase clock, the number of transfer bits is 1. In other words, even when the total number of transfer electrodes is m bits, the effective bit length becomes m/6. Accordingly, even when the same clock data are used, the effective bit length can be reduced to 1/5 by changing the transfer system from the E/B transfer system to the ordinary transfer.

The shift register 72 provided in the drive circuit 70 includes a plurality of D type flip-flops 75A to 75F, and gate circuits 76A to 76F provided at the data input terminal sides thereof as shown in Figure 9. Each of the gate circuits 76A to 76F is formed of a pair of AND gates and an OR gate. One of AND gates 77A to 77F thereof is supplied with the control data which controls the shift direction of the shift register 72, and the AND gate 77A at the first stage is supplied with the clock data which are used in the ordinary transfer.

On the other hand, the other AND gates 78A to 78F thereof are the gates used when the data are shifted from the right-hand side to the left-hand side. They are supplied with the selection data which are used for shifting the data to the right-hand side, and the AND gate 78F at the last stage is supplied with the clock data which are used in the E/B transfer.

The selection data and the clock data are selected by a selecting circuit 80 which selects the shift direction as shown in the figure. The selecting circuit 80 includes a pair of AND gates 81A and 81B which are supplied in common with predetermined clock data from the transfer clock generator 71. One AND gate 81A is also supplied with the selection data, which the other AND gate 81B is supplied with the selection data through an inverter 82.

Accordingly, when the high level selection data are supplied to a terminal 83, the other AND gate 81B is turned off so that only the clock data, which are passed through one AND gate 81A, are supplied through the gate circuit 76A to the D type flip-flop 75A which forms the shift register 72A at the first stage, thus the clock data are shifted in turn by one bit each from the left-hand side to the right-hand side.

Meanwhile, when the selection data applied to the terminal 83 are at low level, only the other AND gate 81B is operated, so that at this time the clock data are supplied through the AND gate 81B and the AND gate 78F provided in the shift register 72F to the D type flip-flop 75F with the result that the clock data are shifted in turn from the right-hand side to the left-hand side. A clock pulse is supplied to a terminal 84.

As set forth above, by the use of the selecting circuit 80, it becomes possible to use one shift register as the bi-directional shift register.

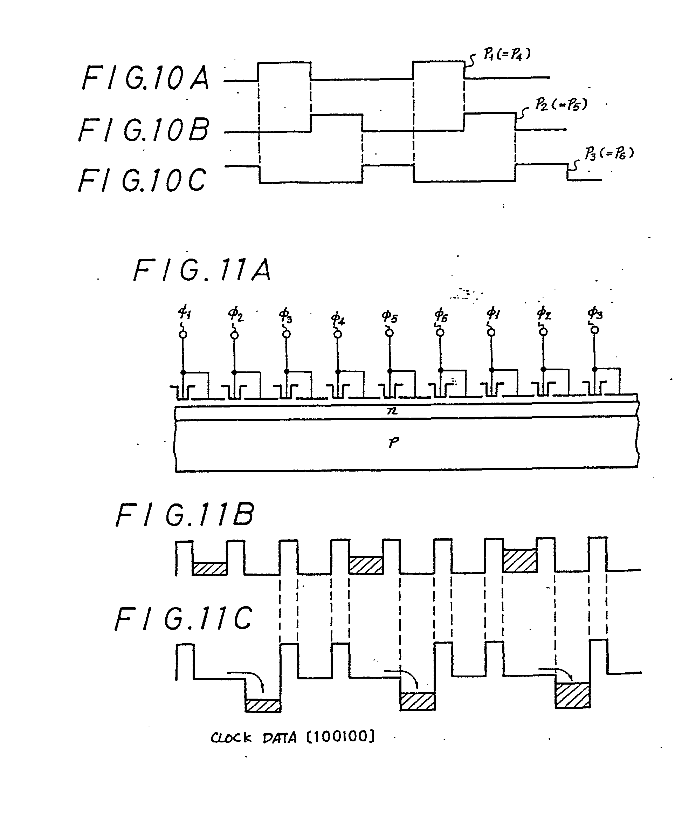

The embodiment of Figure 8 shows the case where the effective bit length is reduced to m/6 bits. Figure 10 and the following drawings show further modified examples. Figures 10 and 11 show the embodiment in which the effective bit length is varied to 2m/6 bits.

Figure 10 is a timing chart of the transfer clocks P1 to P6 used therefor and the clock data are 100100. At that time, the shift register is driven according to the ordinary transfer system and the mode upon transfer is shown in Figure 11.

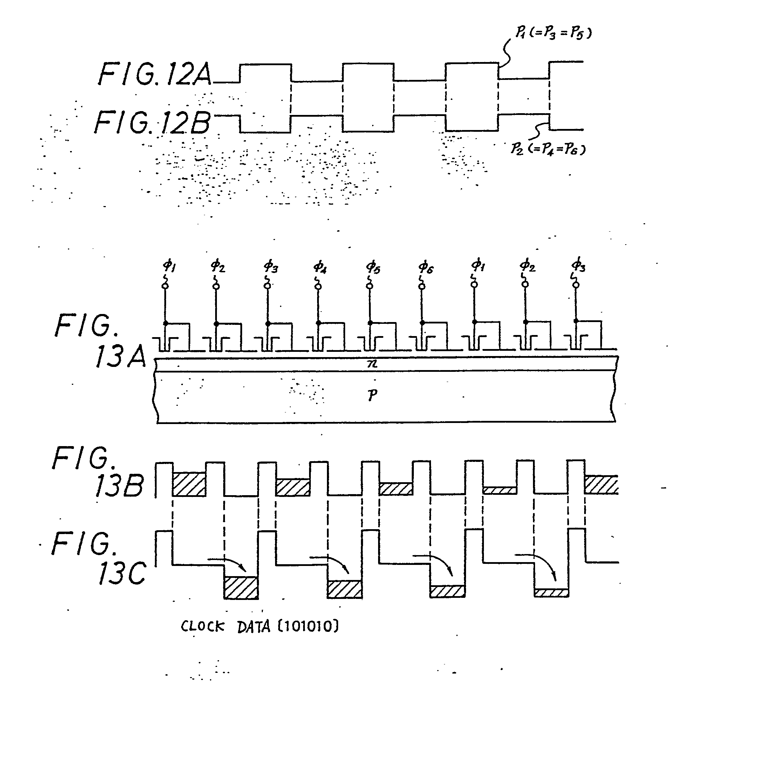

Figure 12 shows the case in which the effective bit length is varied to 3m/6 bits and the clock data are 101010. Figure 12 shows a timing chart of the transfer clocks P1 to P6 based on the clock data, and Figure 13 shows the accumulation state and the transfer state of the signal charge at this time. The shift register is driven according to the ordinary transfer at this time.

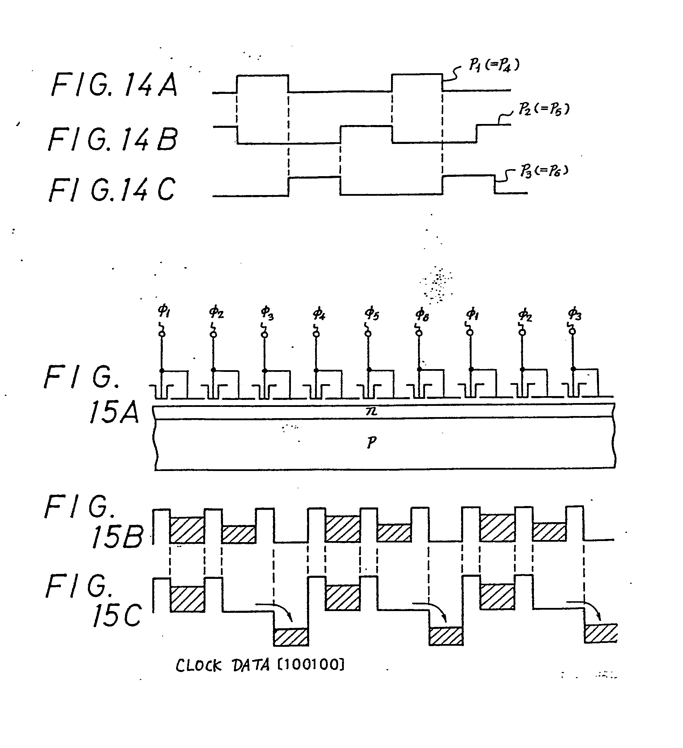

Figure 14 shows the case in which the effective bit length is varied to 4m/6 bits. In this case, the data 100100 are used as the clock data and the transfer system is selected to be the E/B transfer. Figure 14 shows an example of the transfer clocks P1 to P6. Figure 15 shows the accumulation state and the transfer state of the signal charge at that time.

When an embodiment of shift register according to this invention is used for the CCD memory of Figure 1, it is used as the parallel shift register 20R. When the transfer clock generator and the drive circuit are added to the parallel shift register 20R, the effective bit length can arbitrarily be externally varied from m/6 bits to 5m/6 bits.

Therefore, with the same shift register and without varying the peripheral circuits, the capacity of the memory can freely be varied, so that it is not necessary to construct the shift register and the peripheral circuits thereof in accordance with the use.

In this case, it is sufficient that the data from the input shift register 10R are supplied to the second input gate ING2 shown in Figure 4.

Thus, by the selection of the transfer system and the selection of the clock data, the effective bit length of the n-phase and m-bit shift register can arbitrarily be varied from m/n bits to (n-1)m/n bits at maximum, without varying the inner construction of the shift register.

Embodiments of shift register according to the invention can be used, for example, as a field or frame memory having a serial-parallel-serial conversion construction as described above, or of course, as a single shift register.

While in the above embodiments the 6-phase shift register is used as the n-phase and m-bit shift register, the number of phases is not limited. Also, when the shift register is constructed as shown in Figure 9, the provision of a plurality of gate circuits 76A to 76F and the selecting circuit 80 for the shift direction enables the shift register to be used as the bi-directional shift register, so that the construction of the shift register can be greatly simplified. Also, the shift register employ other charge transfer elements other than CCDs.

Moreover, while in Figure 3 the predetermined effective bit length can be obtained by externally controlling the transfer clock generator 71, it is possible that the clock data and the selection data are stored in a read only memory or the like, and then selected externally. Furthermore, when the transfer electrodes φ1 to φ6 and the outputs of the clock drives 73A to 73F are connected together, if the connection is changed, without modifying the inner construction of the shift register, a shift register having any one of the bit lengths in the above embodiments can be formed.

## Claim

A shift register (60) comprising an n-phase and m-bit charge transfer type shift register (60) and a drive circuit (70) for said shift register (60), wherein the bit capacity of said shift register (60) can be varied to (n-1)m/n bits at maximum by driving said shift register (60) on the basis of a predetermined transfer clock which is generated from said drive circuit (70);

characterized in that:

said drive circuit (70) comprises a transfer clock generator (71) producing clock data, and a bi-directional m-bit shift register (72A to 72F) receiving said clock data via selection means either on a first input for selection of a first transfer (electrode/bit transfer), whereby the clock data is shifted in turn in said shift register (72A to 72F) in a first direction, or on a second input for selection of a second transfer (ordinary transfer), whereby the clock data is shifted in turn in said shift register (72A to 72F) in the other direction, and a respective clock driver (73A to 73F) connected to each of the bits of said bi-directional shift register (72A to 72F), the effective bit length of the shift register (60) being determined by the bits of the clock data and by selecting the transfer direction.

## Patentanspruch

Schieberegister (60) mit einem n-Phasen-m-Bit-Schieberegister (60) vom Ladungstransfertyp und einer Treiberschaltung (70) für das Schieberegister (60), wobei die Bit-Kapazität des Schieberegisters (60) auf maximal (n-1)r/n Bits veränderbar ist, indem es auf der Basis eines von der Treiberschaltung (70) erzeugten vorbestimmten Transfertakts betrieben wird,

dadurch gekennzeichnet,

daß die Treiberschaltung (70) einen Transfertaktgenerator (71) zur Erzeugung von Taktdaten sowie ein bidirektionales m-Bit-Schieberegister (72A bis 72F) aufweist, das die Taktdaten über Auswahlmittel

entweder an einem ersten Eingang aufnimmt, um einen ersten Transfermodus (Elektroden/Bit-Transfer) auszuwählen, wodurch die Taktdaten in einer ersten Richtung der Reihe nach in das Schieberegister (72A bis 72F) geschoben werden,

oder an einem zweiten Eingang, um einen zweiten Transfermodus (normaler Transfer) auszuwählen, wodurch die Taktdaten in der anderen Richtung der Reihe nach in das Schieberegister (72A bis 72F) geschoben werden, und

daß an jede Bitstufe des bidirektionalen Schieberegisters (72A bis 72F) jeweils ein Takttreiber (73A bis 73F) angeschlossen ist,

wobei die effektive Bitlänge des Schieberegisters (60) durch die Bits der Taktdaten und durch Auswahl der Transferrichtung festlegbar ist.

## Revendication

Registre à décalage (60) comportant un registre à décalage (60) du type à transfert de charge à n phase set m bits et un circuit d'attaque (70) dudit registre à décalage (60), dans lequel la capacité binaire dudit registre à décalage (60) peut être modifiée jusqu'à (n-1)m/n bits au maximum en attaquant ledit registre à décalage (60) sur la base d'une horloge de transfert prédéterminée qui est produite par ledit circuit d'attaque (70);

caractérisé en ce que:

ledit circuit d'attaque (70) comporte un générateur d'horloge de transfert (71) produisant des données d'horloge et un registre à décalage bidirectionnel (72A à 72F) à m bits qui reçoit lesdites données d'horloge par l'intermédiaire d'un dispositif de sélection, soit sur une première entrée pour la sélection d'un premier transfert (transfert électrode/bit), de manière que les données d'horloge soient décalées tour à tour dans ledit registre à décalage (72A à 72F) dans un premier sens, soit sur une seconde entrée pour la sélection d'un second transfert (transfert ordinaire) de manière que les données d'horloge soient décalées tour à tour dans ledit registre à décalage (72A à 72F) dans l'autre sens et un pilote d'horloge respectif (73A à 73F) connecté à chacun des bits dudit registre à décalage bidirectionnel (72A à 72F), la longueur binaire effective du registre à décalage (60) étant déterminée par les bits des données d'horloge et par la sélection du sens du transfert.

# F I G . 1

# F I G . 2

# FIG. 3

FIG.
5A

FIG.
5B

FIG.
5C

FIG.
5D

FIG.
5E

FIG.
5F

CLOCK DATA [100000]

2

EP 0 099 931 B1

IN3  ING₁  ING₂  $\phi_1$  $\phi_2$  $\phi_3$  $\phi_4$  $\phi_5$  $\phi_6$

*FIG. 4A*

$n^+$  $n$

$P$

*FIG. 4B*

*FIG. 4C*

*FIG. 4D*

*FIG. 4E*

$\phi_6$  $\phi_1$  $\phi_2$  $\phi_3$  $\phi_4$  $\phi_5$  $\phi_6$  $\phi_1$  $\phi_2$

FIG. 6A

$n$

$p$

FIG. 6B

FIG. 6C

SIGNAL CHARGE

FIG. 6D

FIG. 6E

CLOCK DATA [100000]

4

FIG. 7A

FIG. 7B

FIG. 7C

FIG. 7D

FIG. 7E

FIG. 7F

FIG. 9

FIG. 8A

FIG. 8B

FIG. 8C

SIGNAL CHARGE

FIG. 8D

FIG. 8E

CLOCK DATA (000001)

FIG.10A

FIG.10B

FIG.10C

$P_1(=P_4)$

$P_2(=P_5)$

$P_3(=P_6)$

FIG.11A

FIG.11B

FIG.11C

CLOCK DATA [100100]

FIG.12A

FIG.12B

$P_1 (= P_3 = P_5)$

$P_2 (= P_4 = P_6)$

$\phi_1$  $\phi_2$  $\phi_3$  $\phi_4$  $\phi_5$  $\phi_6$  $\phi_1$  $\phi_2$  $\phi_3$

FIG. 13A

$n$

$p$

FIG. 13B

FIG. 13C

CLOCK DATA (101010)

*FIG. 14 A*

*FIG. 14 B*

*FI G. 14 C*

$P_1 (=P_4)$

$P_2 (=P_5)$

$P_3 (=P_6)$

*F I G.
15A*

$\phi_1$ $\phi_2$ $\phi_3$ $\phi_4$ $\phi_5$ $\phi_6$ $\phi_1$ $\phi_2$ $\phi_3$

$n$

$P$

*FIG.
15B*

*FIG.
15C*

CLOCK DATA [100100]

9